(19) Europäisches Patentamt
European Patent Office
Office européen des brevets

(11) EP 0 557 090 B1

(12) **EUROPEAN PATENT SPECIFICATION**

(45) Date of publication and mention
of the grant of the patent:
**19.08.1998 Bulletin 1998/34**

(51) Int Cl.[6]: **G01R 33/032**, G01R 15/24

(21) Application number: **93301189.2**

(22) Date of filing: **18.02.1993**

(54) **Optical magnetic field sensor**

Optischer Magnetfeldsensor

Capteur optique de champ magnétique

(84) Designated Contracting States:
**DE FR GB**

(30) Priority: **21.02.1992 JP 35037/92**

(43) Date of publication of application:
**25.08.1993 Bulletin 1993/34**

(73) Proprietor: **NGK INSULATORS, LTD.**
**Nagoya City Aichi Pref. (JP)**

(72) Inventors:
• **Okajima, Hisakazu**
**Nishikasugai-Gun, Aichi Pref. (JP)**
• **Noda, Masaki**
**Nagoya City, Aichi Pref. (JP)**

(74) Representative: **Paget, Hugh Charles Edward et al**
**MEWBURN ELLIS**
**York House**
**23 Kingsway**
**London WC2B 6HP (GB)**

(56) References cited:
**EP-A- 0 390 581**      **EP-A- 0 410 234**
**US-A- 4 973 899**

• **IEEE TRANS. ON POWER DELIVERY, vol.2, no.1, January 1987, US pages 87 - 93 T.MITSUI ET AL. 'Development of Fiber-Optic Voltage Sensors and Magnetic-Field Sensors'**
• **IEEE TRANS. ON POWER DELIVERY, vol.5, no.2, April 1990, US pages 892 - 898 E.A.ULMER 'A High-Accuracy Optical Current Transducer for Electric Power Systems'**
• **APPLIED OPTICS, vol.28, no.11, June 1989, NEW YORK US pages 2001 - 2011 K.S.LEE 'New compensation method for bulk optical sensors with multiple birefringences'**
• **PATENT ABSTRACTS OF JAPAN vol. 9, no. 9 (P-327) 16 January 1985 & JP-A-59 159 076 (HITACHI SEISAKUSHO)**

**Description**

The present invention relates to an optical magnetic field sensor, particularly an optical magnetic field sensor which can measure a magnetic field strength with high precision using Faraday's effect.

Heretofore, various structures of the optical magnetic field sensor have been known which uses Faraday's effect for measuring a magnetic field strength. As an example, JP-A-61-82,179 discloses a method of measuring a magnetic field strength capable of making the measurement with high precision wherein a light beam intensity ratio of two (P and S) polarized light beams passed through a Faraday element and emitted from an analyzer is used to correct errors resulting from light beam losses at the light beam transmission paths which are not relative to the Faraday's effect.

In the technique of the above JP-A-61-82,179, a light beam intensity ratio a ($=J_1/J_2$) of a P polarized light beam intensity $J_1$ to a S polarized light beam intensity $J_2$ emitted from an analyzer is preliminarily determined at the time when a magnetic field is not applied on the optical magnetic field sensor, and a treatment of regularization of signals at the time of receiving the signals when a magnetic field is applied on the optical magnetic field sensor is performed wherein the S polarized light beam intensity $J_2$ is multiplied by the above ratio a, so that the errors resulting from light beam losses at the light transmission paths can be corrected. However, the technique of JP-A-61-82,179 performs merely the treatment of regularization of signals of multiplicating $J_2$ by the above ratio a, so that signal errors resulting from temperature could not be corrected and a problem arose in that it cannot be used as a highly precise optical magnetic field sensor suitable for use at large temperature change.

US-A-4973899 discloses a current sensor using the Faraday effect in which two electrical signals are derived from two mutually perpendicular components of the polarized light beam emitted by the magneto-optic element. The two signals are processed as follows. The first electrical signal is processed by: filtering an AC component of the first electrical signal to produce a first filtered output signal; filtering a DC component of the first electrical signal to produce a second filtered output signal; and calculating a ratio $S_1$ of the first and second filtered output signals. The second electrical signal is processed by: filtering an AC component of the second electrical signal to produce a third filtered output signal; filtering a DC component of the second electrical signal to produce a fourth filtered output signal; and calculating a ratio $S_2$ of the third and fourth filtered output signals. An AC component of the current is then calculated in accordance with the calculation:

$$(2 \cdot S_1 \cdot S_2)/(S_2 - S_1).$$

A DC component of the current is then calculated in accordance with the calculation:

$$(S_2 + S_1)/(S_2 - S_1).$$

In this way, the AC and DC components of the measured current are obtained. This procedure is stated to solve various problems in Faraday effect devices.

An object of the present invention is to obviate the above problem so as to provide an optical magnetic sensor which can measure a magnetic field strength with high precision with reduced or zero measurement errors resulting from temperature change.

The present invention is an optical magnetic field sensor as set out in claim 1.

The optical magnetic field sensor of the present invention has the structure as mentioned above of adding the third calculation circuit to the structure of an optical magnetic field sensor which is substantially the same as the prior art, so that measurement errors caused by losses in the light beam paths are excluded by the regularization (normalization) of the signals, and errors caused by temperature change are largely or entirely excluded from the signals from the first and second calculation circuits by the calculation at the third calculation circuit. Therefore, a magnetic field strength can be measured with high precision.

For a better understanding of the present invention, reference is made to the accompanying drawings, in which:

Fig. 1 is a schematic block diagram showing a structure of an embodiment of the optical magnetic field sensor of the present invention;

Fig. 2 is a schematic block diagram showing a structure of an optical magnetic field sensor of a comparative example;

Figs. 3a, 3b and 3c are graphs for the present optical magnetic field sensor showing an example of temperature characteristics relative to $V_{11}$ output change ratio, $V_{22}$ output change ratio, and $V_3$ output change ratio, respectively.

Figs. 4a, 4b and 4c are graphs for the present optical magnetic field sensor showing another example of temperature characteristics relative to $V_{11}$ output change ratio, $V_{22}$ output change ratio, and $V_3$ output change ratio,

respectively; and

Figs. 5a, 5b and 5c are graphs for the present optical magnetic field sensor showing still another example of temperature characteristics relative to $V_{11}$ output change ratio, $V_{22}$ output change ratio, and $V_3$ output change ratio, respectively.

Hereinafter, the present invention will be explained in more detail, with reference to embodiments.

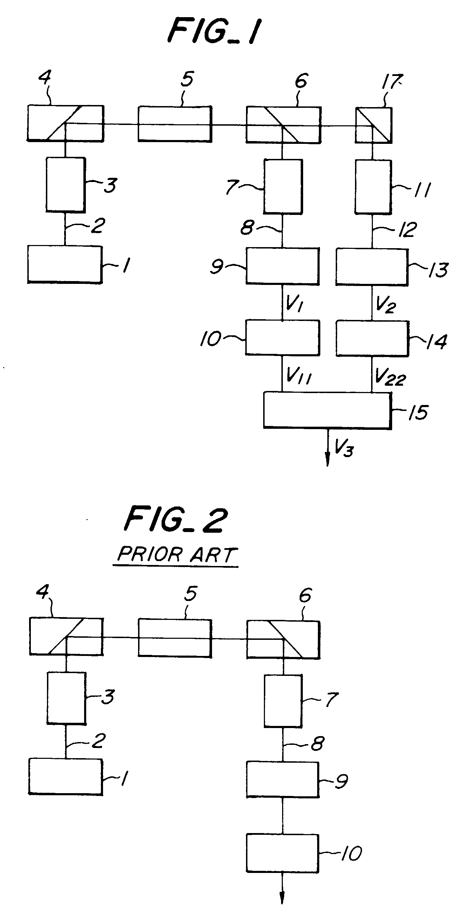

Referring to Fig. 1 showing a structure of an embodiment of the present optical magnetic field sensor, reference numeral 1 is a light source made of LED, 2 is an optical fiber forming a light beam transmission path, 3 is a rod lens which causes distributed light beams to parallel light beams, 4 is a polarizer which makes a light beam to a linear polarized light beam, 5 is a Faraday's element made of $Bi_{12}SiO_{20}$ which causes the linear polarized light beam to rotate to give Faraday's effect depending on a given magnetic field strength, and 6 is an analyzer which separates a given linear polarized light beam into a S polarized light beam and a P polarized light beam.

In addition, reference numeral 7 is a first rod lens for condensing parallel light beams of the analyzer 6, 8 is a first optical fiber forming a light beam transmission path, 9 is a first light beam-receiving element made of a photodiode for converting the S polarized light beam into an electric signal depending the strength thereof, 10 is a first calculation circuit for calculating and multiplicating the converted electric signal to exclude measuremental errors and the like resulting from losses in the light beam path, 11 is a second rod lens for condensing parallel light beams of the P polarized light beams separated at the analyzer 6, 12 is a second optical fiber forming a light beam transmission path, 13 is a second light beam receiving element made of a photodiode for converting the P polarized light beam into an electric signal depending on the strength thereof, and 14 is a second calculation circuit for calculating and multiplicating the converted electric signal to exclude measuremental errors and the like resulting from losses in the light beam path. The multiplication ratio in the first calculation circuit 10 is equal to that in the second calculation circuit 14.

The structure just described above is substantially the same as in the prior art optical magnetic field sensor, but a characteristic feature of the present invention is the provision of a third calculation circuit 15 which is supplied with the outputs from the first and second calculation circuits 10, 14 to perform a desired calculation so as to exclude measuremental errors resulting from temperature change. That is, the third calculation circuit 15 is supplied with the output $V_{11}$ from the first calculation circuit 10 and the output $V_{22}$ from the second calculation circuit 14, the outputs $V_{11}$ and $V_{22}$ being optionally reversed and multiplicated, to calculate and obtain the output $V_3$ based on the equation $V_3=1/(\alpha/V_{11}-\beta/V_{22})$, wherein $\alpha$ and $\beta$ are constants and $\alpha+\beta=1$.

Hereinafter, the principle of operation of the present optical magnetic field sensor of the aforementioned structure at the respective calculation circuit will be explained.

When the wave length of the light beam emanated from the light source 1 is taken as 850 nm, the length $\ell$ of an element of a single crystal $Bi_{12}SiO_{20}$ is taken as $\ell=4.02$ mm, and the intensity of the incident light beam from the light source 1 is taken as $I_0$, the intensities $I_1$, $I_2$ of the output light beams at the first and second light beam-receiving elements 9, 13 are expressed by the following formula:

$$I_1 = I_0/2\{\ell-2\Delta\phi_0\Delta T\ell-2(V_e+\Delta V_e\Delta T)H\ell\} \tag{1}$$

$$I_2 = I_0/2\{\ell+2\Delta\phi_0\Delta T\ell+2(V_e+\Delta V_e\Delta T)H\ell\} \tag{2}$$

wherein

$\Delta\phi_0$ : Temperature change ratio of natural light rotational ability
$\Delta T$ : Temperature variation from 25°C
$\ell$ : Length of the single crystal element
$V_e$ : Verdet's constant
$\Delta V_e$ : Verdet's constant temperature change ratio
H : Alternate current magnetic field strength

In the first and second calculation circuits 10, 14, the circuits are supplied with the electric signals $V_1$, $V_2$ from the first and second light beam-receiving elements 9, 13, respectively, the electric signal $V_1$ and $V_2$ having respective direct current components DC1 and DC2, to obtain the outputs $V_{11}$ and $V_{22}$ of the following formula based on the equations of $V_{11}=(V_1-DC1)/DC1$ and $V_{22}=(V_2-DC2)/DC2$.

$$V_{11} = -2(V_e + \Delta V_e \Delta T) H\ell/(1 - 2\Delta\phi_0 \Delta T\ell) \qquad (3)$$

$$V_{22} = 2(V_e + \Delta V_e \Delta T) H\ell/(1 + 2\Delta\phi_0 \Delta T\ell) \qquad (4)$$

In this case, if $V_3$ is defined as $V_3 = 1/(\alpha/V_{11} - \beta/V_{22})$ and $\alpha + \beta = 1$, the following formula (5) can be obtained.

$$V_3 = -2(V_e + \Delta V_e \Delta T) H\ell/\{1 - 2(2\alpha - 1)\Delta\phi_0 \Delta T\ell\} \qquad (5)$$

Therefore, in order that the output $V_3$ expressed by the formula (5) is not dependent on temperature, it is only necessary to fulfill the following formula (6).

$$V_3(\Delta T) = V_3(\Delta T = 0) \qquad (6)$$

Accordingly, a value $\alpha$ of $\alpha = (1 - \Delta V_e/2V_e \Delta\phi_0\ell)/2$ is obtained to derive values of $\alpha = 0.6805$ and $\beta = 0.3195$ in this embodiment.

Three types of optical magnetic field sensor consisting of an embodiment of the present invention of the above structure, the comparative example of the structure as shown in Fig. 2 and a prior example of JP-A-61-82179 as explained above were actually prepared to obtain a relation between the magnetic field strength and the output, output change due to change of the amount of the light beam, and output change due to temperature change, respectively. As a result, the following data as shown in the following Table 1 were obtained to ascertain that the output $V_3$ can be measured in proportion with the alternate current magnetic field strength H in the embodiment of the present invention without depending on output changes due to change of the amount of the light beam or loss in the light transmission path and change of temperature as compared with the comparative example and the prior example.

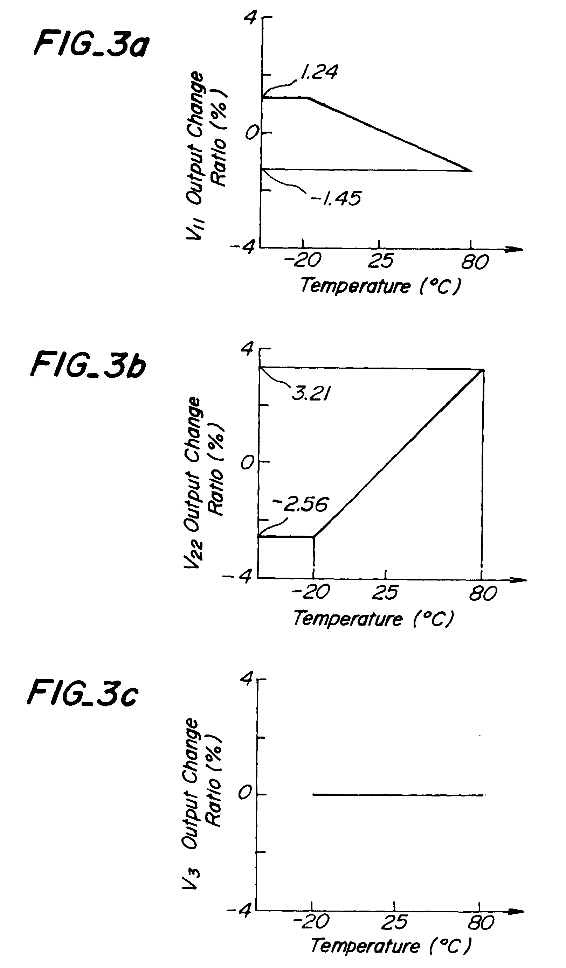

Moreover, in the embodiment of the present invention, the temperature of the sensor was varied in a range of -20°C through 80°C, and output change ratios relative to the output at 25°C were measured to evaluate the temperature characteristic property of the present sensor. The results are shown in Figs. 3a-3c. As seen from Figs. 3a-3c, it can be understood that the output $V_3$ of the third calculation circuit 15 which is a characteristic feature of the present invention was not at all influenced by temperature change, even when the outputs $V_{11}$ and $V_{22}$ of the first and second calculation circuits 9, 13 were influenced by the temperature change.

## Table 1

| Item / Example | Relation between magnetic field strength and output | Output change due to change of light beam amount | Output change due to temperature change |
|---|---|---|---|
| Comparative | Proportional | None | Yes |
| Prior | Proportional | None | Yes |
| Invention | Proportional | None | None |

Though the temperature characteristic property in the above embodiment is not always 0% at the values of the constants $\alpha = 0.6805$ and $\beta = 0.3195$ due to errors in the element length and errors resulting from increasement of the effective element length caused by oblique bonding of the elements, however, even in such a case, the temperature characteristic property can be made 0%, if the constants $\alpha$, $\beta$ are deductively derived from actually measured temperature characteristic properties of $V_{11}$ and $V_{22}$ and the thus obtained optimum $\alpha$, $\beta$ are used to the outputs treatment or regularization of the signals at the third calculation circuit 15.

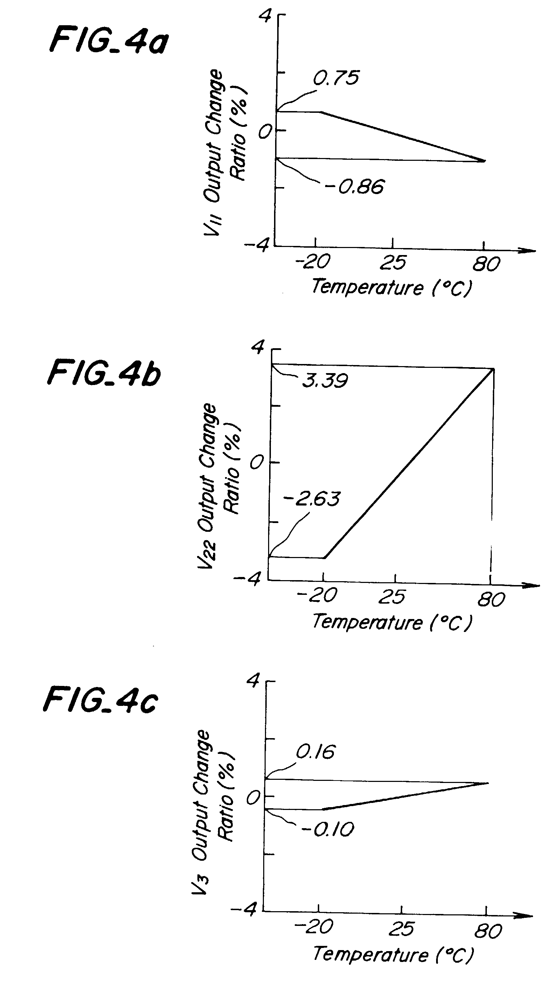

For instance, in case when the element length $\ell$ is short resulting from an error or the like and the temperature characteristic properties of $V_{11}$ and $V_{22}$ are as shown in Figs. 4a and 4b, the temperature characteristic property of the

output $V_3$ changes as shown in Fig. 4c, if the above values are treated in the third calculation circuit 15 using the values of $\alpha=0.6805$ and $\beta=0.3195$. Then, from the outputs $V_{11}$ and $V_{22}$ at -20°C and the outputs $V_{11}$ and $V_{22}$ at 80°C, the constants $\alpha$, $\beta$ are deductively derived as follows, namely from the formula (7).

$$\alpha/V_{11}(-20°C)+\beta/V_{22}(-20°C)=\alpha/V_{11}(80°C)+\beta/V_{22}(80°C) \qquad (7)$$

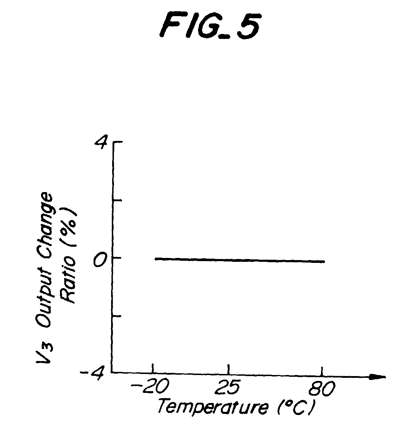

As a result, in the embodiment wherein the element length is shorter than normal one, values of $\alpha=0.7222$ and $\beta=0.2778$ were obtained which gave the temperature characteristic property $V_3$ as shown in Fig. 5 by the outputs treatment, showing clearly that the outputs can be treated in the third calculation circuit 15 by using the deductively derived values of $\alpha$, $\beta$.

As clearly apparent from the foregoing explanations, according to the present invention, the present optical magnetic field sensor can achieve measurements of a magnetic field strength with high precision, because it has further the third calculation circuit in addition to the structure of the optical magnetic field sensor having substantially the same structure as that of conventional one thereby to exclude measuremental errors caused by temperature change from the outputs obtained from the first and second calculation circuits by virtue of the determined the outputs treatment at the third calculation circuit. Moreover, measuremental errors caused by change of the amount of the light beam emanated from the light source and losses in the light beam transmission paths can be excluded because it performs calculations for regularization of the outputs at the first and second calculation circuits in the same fashion as in conventional ones.

Although the present invention has been explained with specific examples and numeral values, it is of course apparent to those skilled in the art that various changes and modifications are possible.

## Claims

1. An optical magnetic field sensor, comprising a light source (1), a polarizer (4) which changes a light beam emanated from the light source through an optical fiber transmission path (2) into a linear polarized light beam, a Faraday's element (5) which gives a Faraday's effect to the linear polarized beam depending on an applied magnetic field, an analyzer (6) which separates the linear polarized light beam given with the Faraday's effect into a S polarized light beam and a P polarized light beam, a first light beam-receiving element (9) which receives and changes the S polarized light beam into an electric signal $V_1$ depending on the beam intensity, a second light beam receiving element (13) which receives and changes the P polarized light beam into an electric signal $V_2$ depending on the beam intensity, a first calculation circuit (10) which is supplied with the electric signal $V_1$ having a direct current component DC1 from the first light beam-receiving element to obtain an output $V_{11}$ based on an equation $V_{11}=(V_1-DC1)/DC1$, a second calculation circuit (14) which is supplied with the electric signal $V_2$ having a direct current component DC2 from the second light beam-receiving element to obtain an output $V_{22}$ based on an equation $V_{22}=(V_2-DC2)/DC2$, and a third calculation circuit (15) which is supplied with the outputs $V_{11}$ and $V_{22}$ to obtain an output $V_3$ based on the equation $V_3=1/(\alpha/V_{11}-\beta/V_{22})$, wherein $\alpha$ and $\beta$ are constants and $\alpha+\beta=1$, the output $V_3$ of the third calculation circuit being a decisive value for obtaining a magnetic field strength,
characterized in that
the values of $\alpha,\beta$ in the third calculation circuit are deductively derived from temperature characteristic properties of actually measured $V_{11}$ and $V_{22}$ in order to compensate measurement errors caused by temperature changes.

## Patentansprüche

1. Optischer Magnetfeldsensor, umfassend eine Lichtquelle (1), einen Polarisator (4), der einen von der Lichtquelle durch einen Lichtleitfaser-Übertragungsweg (2) abgegebenen Lichtstrahl in einen linearen polarisierten Lichtstrahl umwandelt, ein Faraday-Element (5), das auf den linearen polarisierten Strahl in Abhängigkeit eines angelegten Magnetfelds einen Faraday-Effekt ausübt, einen Analysator (6), der den linearen polarisierten Lichtstrahl, auf den der Faraday-Effekt ausgeübt wurde, in einen S-polarisierten Lichtstrahl und einen P-polarisierten Lichtstrahl teilt, ein erstes Lichtstrahl-Empfangselement (9), das den S-polarisierten Lichtstrahl empfängt und in ein elektrisches Signal $V_1$ umwandelt, das von der Strahlenintensität abhängt, ein zweites Lichtstrahl-Empfangselement (13), das den P-polarisierten Lichtstrahl empfängt und in ein elektrisches Signal $V_2$ umwandelt, das von der Strahlenintensität abhängt, eine erste Berechnungsschaltung (10), der das elektrische Signal $V_1$ mit einer Gleichstromkomponente DC1 vom ersten Lichtstrahl-Empfangselement zugeführt wird, um eine Ausgangsgröße $V_{11}$ auf Basis einer

Gleichung $V_{11} = (V_1\text{-}DC1)/DC1$ zu erhalten, eine zweite Berechnungsschaltung (14), der das elektrische Signal $V_2$ mit einer Gleichstromkomponente DC2 vom zweiten Lichtstrahl-Empfangselement zugeführt wird, um eine Ausgangsgröße $V_{22}$ auf Basis einer Gleichung $V_{22}=(V_2\text{-}DC2)/DC2$ zu erhalten, und eine dritte Berechnungsschaltung (15), der die Ausgangsgrößen $V_{11}$ und $V_{22}$ zugeführt werden, um eine Ausgangsgröße $V_3$ auf Basis der Gleichung $V_3 = 1/(\alpha/V_{11}\text{-}\beta/V_{22})$ zu erhalten, worin $\alpha$ und $\beta$ Konstanten sind und $\alpha + \beta = 1$ ist, wobei die Ausgangsgröße $V_3$ der dritten Berechnungsschaltung ein entscheidungskräftiger Wert zum Erhalten der Magnetfeldstärke ist, dadurch gekennzeichnet, daß

die Werte von $\alpha$, $\beta$ in der dritten Berechnungsschaltung deduktiv von Temperaturmerkmalseigenschaften tatsächlich gemessener $V_{11}$ und $V_{22}$ Werte abgeleitet werden, um durch Temperaturänderungen verursachte Meßfehler zu kompensieren.

## Revendications

1. Capteur optique de champ magnétique, comprenant une source de lumière (1), un polariseur (4) qui change un faisceau de lumière émanant de la source de lumière par un trajet de transmission à fibre optique (2) en un faisceau de lumière polarisée linéaire, un élément de Faraday (5) qui donne un effet Faraday au faisceau polarisé linéaire selon un champ magnétique appliqué, un analyseur (6) qui sépare le faisceau de lumière polarisée linéaire (2), auquel a été donné l'effet Faraday, en un faisceau de lumière polarisée (S) et un faisceau de lumière polarisée (P), un premier élément (9) récepteur du faisceau de lumière qui reçoit et change le faisceau de lumière polarisée (S) en un signal électrique $V_1$ dépendant de l'intensité du faisceau, un deuxième élément récepteur du faisceau de lumière (13) qui reçoit et change le faisceau de lumière polarisée (P) en un signal électrique $V_2$ dépendant de l'intensité du faisceau, un premier circuit de calcul (10) qui reçoit le signal électrique $V_1$ ayant une composante en courant continu DC1 du premier élément de réception du faisceau de lumière pour obtenir une sortie $V_{11}$ basée sur une équation $V_{11}=(V_1\text{-}DC1)/DC1$, un deuxième circuit de calcul (14) qui reçoit le signal électrique $V_2$ ayant une composante en courant continu DC2 du deuxième élément de réception du faisceau lumineux pour obtenir une sortie $V_{22}$ basée sur une équation $V_{22}=(V_2\text{-}DC2)/DC2$, et un troisième circuit de calcul (15) qui reçoit les sorties $V_{11}$ et $V_{22}$ pour obtenir une sortie $V_3$ basée sur l'équation $V_3=1/(\alpha/V_{11}\text{-}\beta/V_{22})$, où $\alpha$ et $\beta$ sont des constantes et $\alpha+\beta=1$, la sortie $V_3$ du troisième circuit de calcul étant une valeur décisive pour obtenir la force d'un champ magnétique,

   caractérisé en ce que

   les valeurs de $\alpha$, $\beta$ dans le troisième circuit de calcul sont déductivement dérivées des propriétés caractéristiques de température de $V_{11}$ et $V_{22}$ réellement mesurées afin de compenser des erreurs de mesure provoquées par des changements de température.

## FIG_1

## FIG_2
### PRIOR ART

7

FIG_3a

FIG_3b

FIG_3c

8

FIG_4a

FIG_4b

FIG_4c

# FIG. 5